(19) Europäisches Patentamt
European Patent Office
Office européen des brevets

(11) **EP 2 424 143 A1**

(12) **EUROPEAN PATENT APPLICATION**
published in accordance with Art. 153(4) EPC

(43) Date of publication:
**29.02.2012 Bulletin 2012/09**

(21) Application number: **10766762.8**

(22) Date of filing: **17.02.2010**

(51) Int Cl.:
*H04J 99/00* (2009.01)    *H03M 13/25* (2006.01)
*H03M 13/27* (2006.01)    *H03M 13/29* (2006.01)
*H04B 7/04* (2006.01)    *H04J 11/00* (2006.01)
*H04L 1/00* (2006.01)

(86) International application number:
**PCT/JP2010/001000**

(87) International publication number:
**WO 2010/122699 (28.10.2010 Gazette 2010/43)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **24.04.2009 JP 2009106566**

(71) Applicant: **Panasonic Corporation
Kadoma-shi
Osaka 571-8501 (JP)**

(72) Inventors:
• **YOSHII, Isamu
Osaka 540-6207 (JP)**
• **KISHIGAMI, Takaaki
Osaka 540-6207 (JP)**

(74) Representative: **Grünecker, Kinkeldey,
Stockmair & Schwanhäusser
Anwaltssozietät
Leopoldstrasse 4
80802 München (DE)**

(54) **WIRELESS COMMUNICATION DEVICE AND WIRELESS COMMUNICATION METHOD**

(57)    To lessen a disparity in stream mapping of transmission data when modulation data are mapped into a plurality of streams and when the plurality of streams are transmitted and received. In a wireless communication device, a stream mapper (14) that performs mapping into a plurality of streams sequentially maps a modulation symbol sequence output from a modulator (13) into a plurality of streams for each block output from a channel interleaver (12) that performs channel interleaving, such as sub-block interleaving. On this occasion, a stream mapping method is changed in predetermined unit commensurate with a block size; for instance, at each position of a sub-block length where sub-block interleaving is performed or at each position of a half sub-block length.

*FIG.1*

**Description**

Technical Field

The present inv4ention relates to a wireless communication device and a wireless communication method applicable for a wireless communication system for transmitting a plurality of streams.

Background Art

Multimedia communication, such as data communication and video communication, has recently become brisk in the field of wireless communication. One of wireless communication standards for enabling implementation of high speed communication is called WiMAX. The IEEE has already settled 802.16e standards, and 802.16m standards are now under review as its next generation standards. In connection with the 802.16m standards, application of MIMO (Multiple Input and Multiple Output) for transmitting and receiving a plurality of streams by use of a plurality of antennas is under consideration.

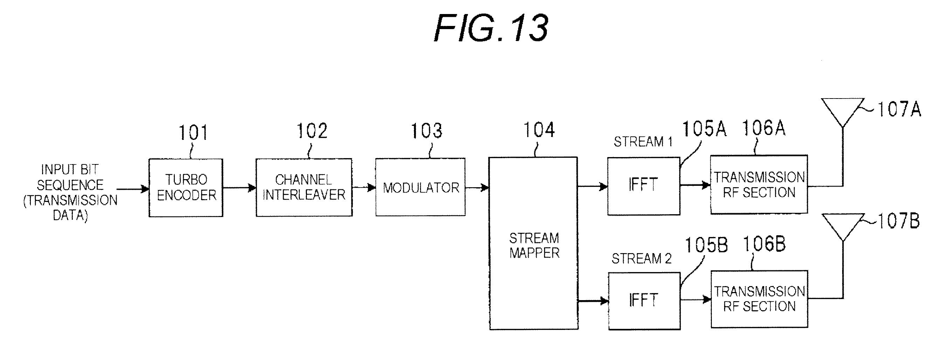

Fig. 13 is a block diagram showing an example configuration of a transmitter of the wireless communication device that performs transmission by use of a plurality of antennas. Fig. 13 shows an example configuration of the wireless communication device that is compliant with the 802.16e standards and the 802.16m standards and envisioned to perform MIMO transmission by use of two antennas.

First, a turbo encoder 101 encodes an input bit sequence, which serves as transmission data, by use of Turbo codes. Two bit sequences A and B including systematic bits are input to the turbo encoder 101. According to the 802.16e and 802.16m standards, an encoding rate 1/3 is taken as a mother code. Hence, two pairs of parity bits; namely, a Y1/Y2 pair and a W1/W2 pair, are output as parity bits in response to the input of the bit sequences A and B including the systematic bits. A channel interleaver 102 performs channel interleaving between the turbo-encoded systematic bits and the turbo-encoded parity bits. Interleaving (sub-block interleaving) to be performed on a per-sub-block-basis and interlacing of the parity bits are carried out as channel interleaving.

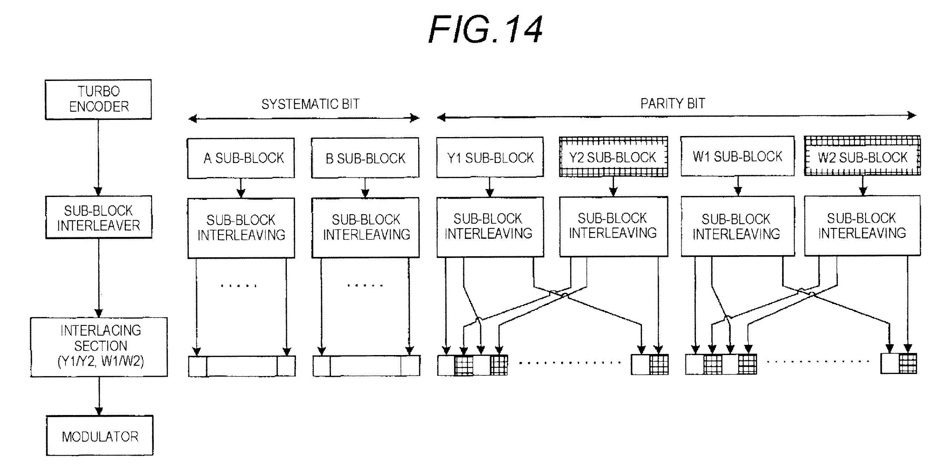

Fig. 14 is a diagram for describing operation of the channel interleaver. The systematic bits A and B and the parity bits Y1, Y2, W1, and W2 that are output from the turbo encoder 101 are input into the channel interleaver 102. The systematic bits A and B and the parity bits Y1, Y2, W1, and W2 are handled as six sub-blocks, respectively. The channel interleaver 102 subjects the systematic bits and the parity bits to interleaving on a per-sub-block basis. All of the sub-blocks are given the same interleave pattern. In relation to the parity bits, the parity bits Y1 and Y2 and the parity bits W1 and W2 are subjected to interlacing, after having undergone sub-block interleaving, in such a way that the parity bits are alternately arranged. After the channel interleaving operation, a modulator 103 performs modulation such as 16QAM.

After modulation, a stream mapper 104 alternately maps a modulation symbol in a direction of an antenna, thereby generating two streams 1 and 2. An IFFT section 105A performs processing for transforming the stream 1 into a time-domain stream by performance of IFFT (Inverted Fast Fourier Transform), and an IFFT section 105B performs processing for transforming the stream 2 into a time-domain stream by performance of IFFT. Subsequently, a transmission RF section 106A converts the stream 1 into a radio frequency of a transmission signal and also subjects the transmission signal to transmission power amplification, or the like. Likewise, a transmission RF section 106B converts the stream 2 into a radio frequency of a transmission signal and subjects the signal to transmission power amplification. Antennas 107A and 107B transmit transmission signals of the two streams. The stream mapper 104 alternately maps the modulation symbol on a per-stream basis. Therefore, even when a certain stream has a poor characteristic, bits having poor characteristics are not consecutive from the viewpoint of a transmission bit. The bits having the poor characteristics are alternately arranged, so that an effect of an error correction code can be sufficiently exhibited.

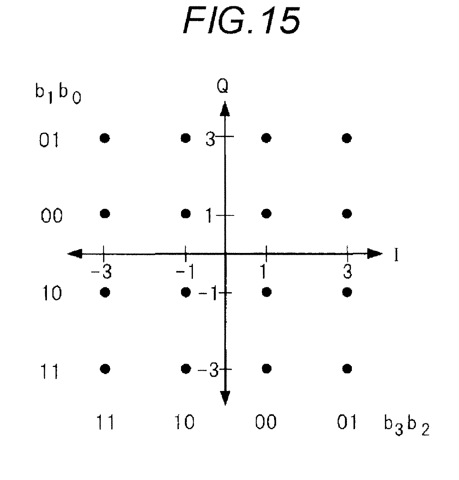

A likelihood of each of the bits achieved when multilevel modulation is performed is now described. Fig. 15 is a plot showing an array of symbols on a 16-QAM complex plane. In the case of 16-QAM modulation, the plane forms a constellation, such as that shown in Fig. 15. Sixteen symbols are arranged over the complex plane, and each of symbols is represented by four bits. Specifically, two bits b3 and b2 are allocated to a direction of an I axis, and two bits b1 and b0 are allocated to a direction of a Q axis. Thus, sixteen symbols on the IQ plane are represented by a total of four bits. In this case, as shown in Fig. 15, the bits b3 and b1 are identical with each other in each of quadrants and do not cause bit inversion between adjacent symbols. Hence, the bits are highly resistant to noise, or the like and exhibit a high degree of reliability and a high likelihood. In the meantime, since the bits b2 and b0 cause bit inversion between adjacent symbols in each of the quadrants, the bits are less resistant to noise, or the like, and exhibit a low degree of reliability and a low likelihood.

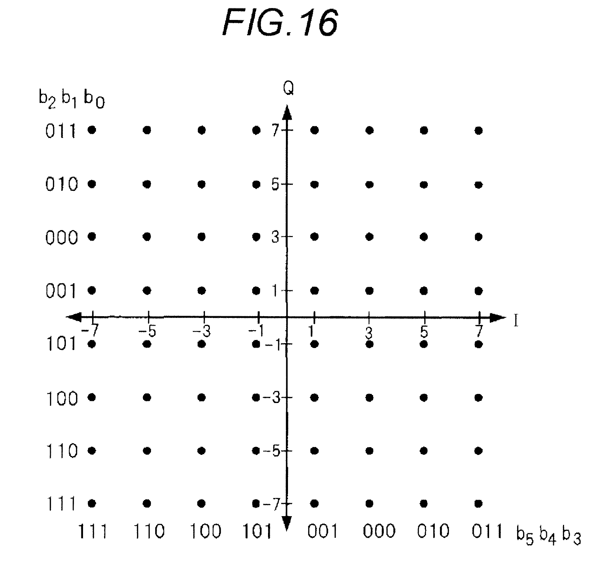

Fig. 16 is a plot showing an array of respective symbols on a 64-QAM complex plane. In the case of 64-QAM modulation, a constellation, such as that shown in Fig. 16, is produced. Sixty-four symbols are put on the complex plane, and each of the symbols is represented by six bits. Specifically, three bits b5, b4, and b3 are allocated to the direction of the I axis, and three bits b2, b1, and b0 are allocated to the direction of the Q axis. Sixty-four symbols on the I-Q plane are represented by a total of six bits. In this case, as shown in Fig. 16, since the bits b5 and b2 are identical in the respective quadrants and do not cause bit inversion between adjacent symbols, the bits are highly resistant to noise, or the like, and exhibit a high degree of reliability and a high likelihood. Further, the bits b4 and b1 cause bit inversion in one-half of each of the quadrants and exhibit an intermediate level of reliability and an intermediate level of a likelihood. Since there is a high probability that the bits b3 and b0 will cause bit inversion between adjacent symbols in each of the quadrants, the bits are less resistant to noise, or the like, and exhibit a low degree of reliability and a low likelihood.

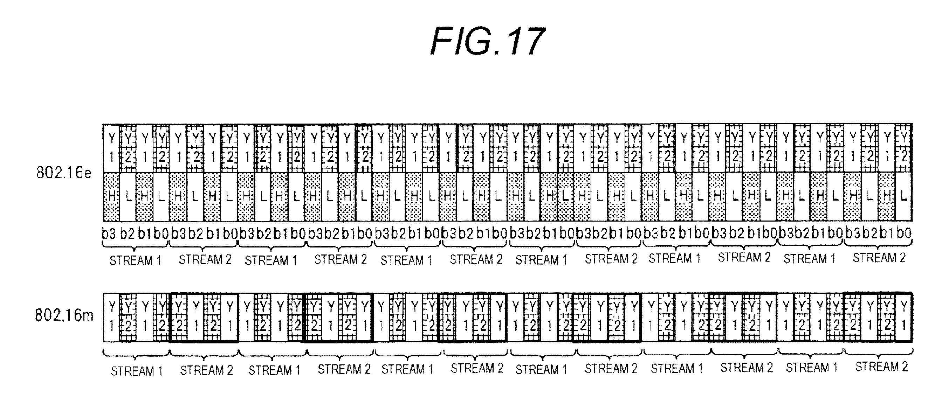

Fig. 17 is a diagram showing example stream mapping performed during multi-level modulation. Fig. 17 shows allocation of parity bits Y1 and Y2 when modulation is performed by means of the 16-QAM symbols. An upper row shows stream mapping conforming to the 802.16e standards, and a lower row shows stream mapping conforming to the 802.16m standards. In Fig. 17, symbol "H" represents a bit exhibiting a high likelihood, and symbol "L" represents a bit exhibiting a low likelihood. The parity bits Y1 and Y2 are alternately arranged by means of interlacing and iteratively allocated, every four bits b3, b2, b1 and b0, to a stream in sequence from the first bit, whereby 16-QAM modulation is performed. The modulation symbols are alternately mapped to the stream 1 and the stream 2 from the first bit. As shown in Fig. 17, in the case of 16-QAM modulation and stream mapping conforming to the 802.16e standards, the parity bit Y1 is allocated to a bit exhibiting a high degree of reliability at all times, and the parity bit Y2 is allocated to a bit exhibiting a low degree of reliability at all times. Because of the disparity in reliability of the allocated bits, the parity bit Y2 exhibits a poor characteristic at all times, which raises a problem of an overall characteristic of the wireless communication device being vulnerable to deterioration.

In order to address the problem, "C-symbol permutation" for changing an order of allocation of bits on a per-modulation-symbol basis has been put forward in connection with the 802.16m standards. As a result of performance of C-symbol permutation, a disparity in reliability between Y1 and Y2 is eliminated, thereby equalizing reliability of the bits to be allocated. An equation of C-symbol permutation is represented by Equation (1) provided below.

[Mathematical Expression 1]

$$
\begin{aligned}
A_i(j) &= (j + (i \bmod C)) \bmod C, && j = 0,\ldots,C-1, i = 0,\ldots,R-1 \\
B_i(j) &= (j + ((i+1+\delta) \bmod C)) \bmod C, && j = 0,\ldots,C-1, i = 0,\ldots,R-1 \\
Y1/Y2_i(j) &= (j + ((i+1) \bmod C)) \bmod C, && j = 0,\ldots,C-1, i = 0,\ldots,R_1-1 \\
W2/W1_i(j) &= (j + ((i+1) \bmod C)) \bmod C, && j = 0,\ldots,C-1, i = 0,\ldots,R_1-1
\end{aligned} \quad \cdots (1)
$$

$$
R = \lfloor N/C \rfloor, R_1 = \lfloor 2N/C \rfloor \qquad \delta = 1 \text{ for } 64 \text{ QAM and } \delta = 0
$$

N: the size of a sub-block; and
C: a multilevel value for multilevel modulation

In the example shown in Fig. 17, an order of allocation of bits to each symbol is changed by turns on a per-modulation-symbol basis; like Y1 and Y2 to Y2 and Y1, by means of performance of C-symbol permutation. The same also applies to W1 and W2.

Citation List

Patent Literature

Patent Literature 1: JP-T-2007-519361

Non-Patent Literature

Non-Patent Literature 1: IEEE 802.16m Contribution C80216m, IEEE 802.16 Broadband Wireless Access Working Group

Summary of the Invention

Technical Problem

As mentioned above, stream mapping has been carried out with a view toward eliminating a disparity between bits by means of allocating a modulation symbol to a stream by turns, to thus disperse the modulation symbols over each of the streams as much as possible. However, if stream mapping is combined with C-symbol permutation proposed in connection with the 802.16m standards, a disparity will arise in a combination of a stream with its degree of reliability, in a deinterleaved bit sequence at a receiving end. Further, the number of continual bits becomes greater on a per-stream basis. As mentioned above, when a signal in the same streams continually appears, error correction capability cannot be sufficiently exhibited, and there arises a case where a characteristic of the wireless communication device may be deteriorated.

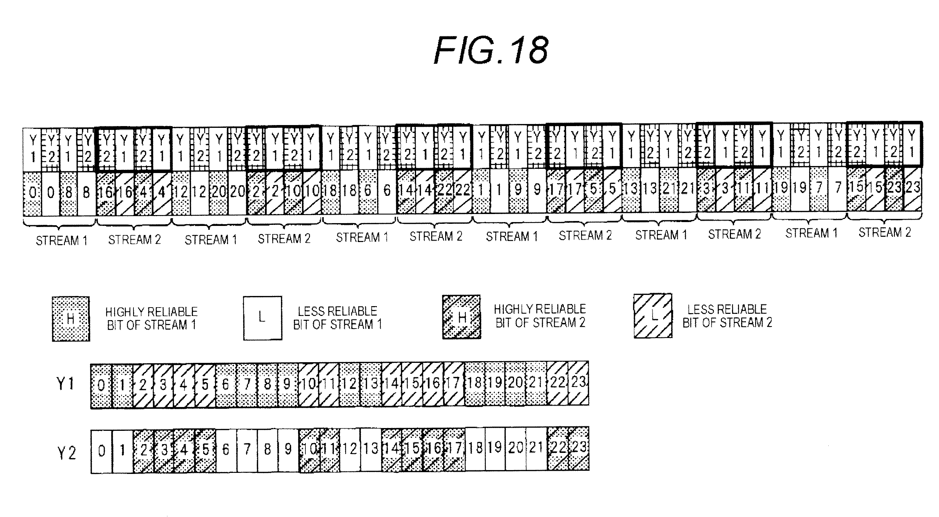

Fig. 18 is a diagram showing a relationship between stream mapping achieved during multilevel modulation and a demodulated bit array achieved at the receiving end. An upper row shown in Fig. 18 shows allocation of the parity bits Y1 and Y2 and a stream mapping acquired when C-symbol permutation is performed during 16QAM multilevel modulation as in the case of 802.16m shown in Fig. 17. In the figure, dot-hatched areas depict bits exhibiting high degrees of reliability. Further, white areas depict bits exhibiting low degrees of reliability. Streams having slanted hatches depict streams 2, and streams not having slanted hatches depict streams 1. A lower row shown in Fig. 18 shows a bit array of the deinterleaved parity bits Y1 and Y2 that have been reconstructed as a result of the streams having undergone demapping, demodulation, and channel deinterleaving at the receiving end.

In this case, as a result of combination of stream mapping with C-symbol permutation, signals originating from the same antenna continually appear (e.g., continual four bits) in relation to each of the deinterleaved parity bits Y1 and Y2. Further, the parity bit Y1 turns into a combination of a highly reliable bit originating from the stream 1 with a less reliable bit originating from the stream 2. Further, the parity bit Y2 turns into a combination of a highly reliable bit originating from the stream 2 with a less reliable bit originating from the stream 1. Therefore, in a case where a difference exists between the streams in terms of a transmission channel characteristic, like a case where a characteristic of a stream transmitted from one antenna becomes deteriorated, there will arise a problem of bits exhibiting poor characteristics becoming continuing or a problem of deterioration of receiving performance.

The present invention has been conceived in light of the circumstance and aims at providing a wireless communication device and a wireless communication method for making it possible to lessen a disparity in stream mapping of transmission data when modulation data into a plurality of streams and when the plurality of streams are received and transmitted.

Solution to Problem

The present invention provides, as a first aspect, a wireless communication device to be used in a wireless communication system for transmitting a plurality of streams, the wireless communication device including: an encoder that is configured to encode a bit sequence to be transmitted; a channel interleaver that includes a sub-block interleaver for subjecting encoded data to sub-block interleaving on a per-sub-block basis; a modulator that is configured to generate a modulation symbol sequence from a bit sequence output from the channel interleaver; a stream mapper that is configured to map the modulation symbol sequence to a plurality of streams; and a transmitter that is configured to transmit the plurality of streams, wherein the stream mapper is configured to sequentially map the modulation symbol sequence to the plurality of streams in each block output from the channel interleaver and to change a stream mapping method in each predetermined unit corresponding to a block size of the block.

The present invention includes, as a second aspect, the wireless communication device, wherein the encoder is configured to generate bit sequences of parity bits in two sub-blocks in response to systematic bits in one sub-block input as the bit sequence, the channel interleaver further includes an interlacing section that is configured to subject the two sub-blocks to interlacing after the sub-block interleaving with regard to the parity bits of the encoded data, and the stream mapper is configured to employ as the block size a sub-block length representing a length of the sub-block, and changes an order of stream mapping at each position of $2N/S$ with regard to the block of the parity bits, where the sub-block length is taken as N and where the number of streams is taken as S.

The present invention includes, as a third aspect, the wireless communication device, wherein the stream mapper alternately changes the order of stream mapping on 1 sub-block length basis with regard to the block of the parity bits when two streams are to be transmitted as the plurality of streams.

The present invention includes, as a fourth aspect, the wireless communication device, wherein the stream mapper changes the order of stream mapping at each position of $N/S$ with regard to the block of the systematic bits.

The present invention includes, as a fifth aspect, the wireless communication device, wherein the stream mapper alternately changes the order of stream mapping on half sub-block length basis with regard to the block of the systematic bits when two streams are to be transmitted as the plurality of streams.

The present invention includes, as a sixth aspect, the wireless communication device, wherein the channel interleaver further includes a C-symbol permutation section that subjects each of the blocks, which is sub-block interleaved or is sub-block interleaved and interlaced, to C-symbol permutation processing for changing an order of bits to be allocated to respective symbols for each modulation symbol in the modulator.

The present invention includes, as a seventh aspect, the wireless communication device, wherein the stream mapper changes the stream mapping method at each position of K/S from a beginning of each of the blocks where the block size is taken as K and where the number of streams is taken as S.

The present invention includes, as an eighth aspect, the wireless communication device, wherein the stream mapper cyclically shifts an order of allocation of streams when changing the stream mapping method.

The present invention includes, as a ninth aspect, the wireless communication device, wherein the modulator performs modulation complying with any one of QPSK, 16QAM, and 64QAM schemes.

The present invention provides, as a tenth aspect, a wireless communication device to be used in a wireless communication system for transmitting a plurality of streams, the wireless communication device including: a receiver that is configured to receive a plurality of streams; a demapper that is configured to perform demapping in response to stream mapping to which the plurality of received streams have been subjected, to generate a modulation symbol sequence from the plurality of received streams; a demodulator that is configured to demodulate the modulation symbol sequence; a deinterleaver that includes a sub-block deinterleaver for subjecting the demodulated bit sequence to sub-block deinterleaving on a per-sub-block basis to reconstruct original encoded data; and a decoder that is configured to decode the encoded data, wherein the demapper is configured to perform demapping corresponding to a block size of a block, which is output from a channel interleaver in a transmitter that has transmitted the plurality of streams when a stream mapping method is changed for each predetermined unit corresponding to the block size in the stream mapping.

The present invention provides, as an eleventh aspect, a wireless communication method in a wireless communication system for transmitting a plurality of streams, the wireless communication method including the steps of: encoding a bit sequence to be transmitted; subjecting encoded data to channel interleaving including sub-block interleaving to be performed on a per-sub-block basis; generating a modulation symbol sequence from the channel-interleaved bit sequence; mapping the modulation symbol sequence to a plurality of streams; and transmitting the plurality of streams, wherein the step of mapping the modulation symbol sequence into the plurality of streams includes sequentially mapping the modulation symbol sequence to the plurality of streams in each block after channel interleaving and changing a stream mapping method in predetermined unit corresponding to a block size of the block.

The present invention includes, as a twelfth aspect, a wireless communication method in a wireless communication system for transmitting a plurality of streams, the wireless communication method including the steps of: receiving a plurality of streams; performing demapping in response to stream mapping to which the plurality of received streams have been subjected, to generate a modulation symbol sequence from the plurality of received streams; demodulating the modulation symbol sequence; reconstructing original encoded data by subjecting the demodulated bit sequence to deinterleaving by a sub-block deinterleaving on a per-sub-block basis; and decoding the encoded data, wherein the step of performing demapping includes performing demapping according to a block size of a block interleaved in a transmitter that has transmitted the plurality of streams when a stream mapping method is changed in each predetermined unit corresponding to the block size in the stream mapping.

By means of the configuration, when the modulation symbol sequence modulated by the modulator is mapped into a plurality of streams after the channel interleaver has performed sub-block interleaving, or the like, the stream mapping method is changed in a predetermined unit commensurate with a block size of a block output from the channel interleaver, whereby a disparity in stream mapping of the transmission data can be lessened. For instance, when a sub-block length representing a length of a sub-block to be subjected to sub-block interleaving is used as the block size; where the sub-block length is taken as N; and where the number of streams is taken as S, an order of stream mapping is changed at each position of 2N/S with regard to the block of parity bits for which two sub-blocks are interleaved. Moreover, the order of stream mapping of blocks of systematic bits is changed at each position of N/S. As a result, adjacent bits that are not yet subjected to sub-block interleaving are allocated to different streams, so that bits of the same streams are prevented from continually appearing in a bit array achieved after deinterleaving at the receiving end. Therefore, when channel interleaving including sub-block interleaving, modulation, and stream mapping are performed, a disparity in degree of reliability of bits in transmission data and occurrence of the same streams continually appearing can be prevented.

Advantageous Effects of the Invention

The present invention can provide a wireless communication device and a wireless communication method for making it possible to lessen a disparity in stream mapping of transmission data when modulation data are mapped into a plurality of streams and when the plurality of streams are received and transmitted.

Brief Description of the Drawings

Fig. 1 is a block diagram showing an example configuration of a transmitter of a wireless communication device according to an embodiment of the present invention.

Fig. 2 is a block diagram showing an example configuration of a receiver of the wireless communication device according to the embodiment of the present invention.

Fig. 3 is a schematic diagram showing a configuration and operation of a turbo encoder employed in the wireless communication device according to the present embodiment.

Fig. 4 is a diagram showing a configuration and operation of a channel interleaver of the wireless communication device according to the present embodiment.

Fig. 5 is a diagram for describing operation of a stream mapper in the wireless communication device according to the present embodiment.

Fig. 6 is a diagram showing first example stream mapping (performed for 16QAM multilevel modulation) according to the present embodiment.

Fig. 7 is a diagram showing second example stream mapping (performed for 64QAM multilevel modulation) according to the present embodiment.

Fig. 8 is a diagram showing third example stream mapping (when four streams are transmitted by use of 64QAM multilevel modulation) according to the present embodiment.

Fig. 9 is a characteristic graph showing an example simulation result yielded when stream mapping according to the present embodiment is used.

Fig. 10 is a block diagram showing an example configuration of a transmitter of a wireless communication device according to another embodiment of the present invention.

Fig. 11 is a diagram showing first example bit interchange operation performed on a per-symbol basis according to the present embodiment.

Fig. 12 is a diagram showing second example bit interchange operation performed on a per-symbol basis according to the present embodiment.

Fig. 13 is a block diagram showing an example configuration of a transmitter of the wireless communication device that performs transmission by way of a plurality of antennas.

Fig. 14 is a diagram for describing operation of a channel interleaver of the transmitter shown in Fig. 13.

Fig. 15 is a plot showing an array of respective symbols plotted on a 16-QAM complex plane.

Fig. 16 is a plot showing an array of respective symbols plotted on a 64-QAM complex plane.

Fig. 17 is a diagram showing example stream mapping performed during multi-level modulation.

Fig. 18 is a diagram showing a relationship between stream mapping achieved during multilevel modulation and a demodulated bit array achieved at a receiving end.

Mode For Carrying Out the Invention

Embodiments show examples of application of a wireless communication device and method of the present invention to a wireless communication system conforming to IEEE 802.16m standards. Exemplified herein are cases where communication of a plurality of streams conforming to MIMO is established between a transmission-end wireless communication device (a transmitter) and a receiving-end wireless communication device (a receiver) by use of a plurality of antennas. Further, multilevel modulation, such as 16QAM and 64QAM, is used as a scheme for modulating transmission data.

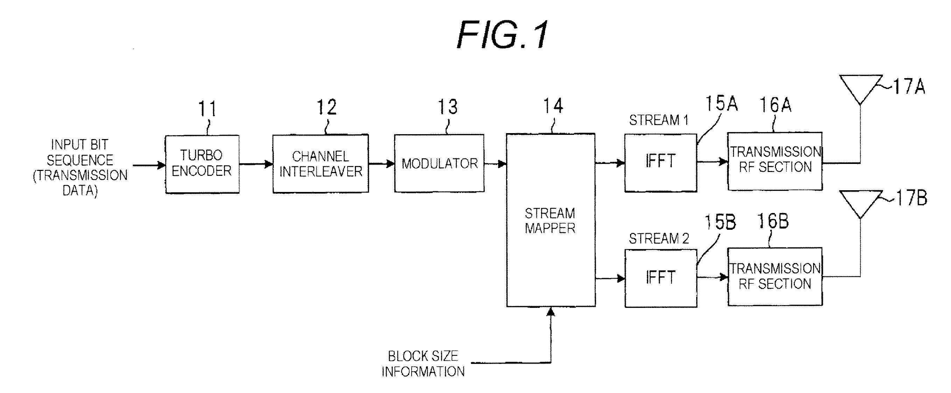

Fig. 1 is a block diagram showing an example configuration of a transmitter of a wireless communication device according to an embodiment of the present invention. Fig. 1 shows an example configuration achieved in a case where two streams are transmitted by means of MIMO and by use of two antennas.

The transmitter of the wireless communication device includes a turbo encoder 11, a channel interleaver 12, a modulator 13, a stream mapper 14, IFFT sections 15A and 15B, transmission RF sections 16A and 16B, and antennas 17A and 17B.

The turbo encoder 11 encodes an input bit sequence as transmission data by use of a Turbo code. The channel interleaver 12 subjects systematic bits and parity bits, which are encoded data output from the turbo encoder 11, to channel interleaving. The channel interleaver 12 performs interleaving on a per-sub-block basis (sub-block interleaving) as channel interleaving and further subjects the parity bits to interlacing. A size of a sub-block to be subjected to sub-block interleaving is now called a sub-block length. A block size of the interlaced parity bits comes to a length of two sub-blocks. The modulator 13 performs modulation conforming to a modulation scheme, such as 16QAM modulation and 64 QAM modulation, thereby generating a modulation symbol sequence from a bit sequence output from the channel interleaver 12.

The stream mapper 14 maps the modulation symbol sequence to a plurality of streams; namely, the stream mapper 14 maps a modulated modulation symbol sequence along a direction of the antenna by turns, thereby generating two streams, or a stream 1 and a stream 2. On this occasion, the stream mapper 14 maps the modulation symbol sequence into a plurality of streams for each of blocks output from the channel interleaver 12. The stream mapper 14 changes a method for mapping a modulation symbol sequence into a plurality of streams in predetermined units commensurate with a block size, such as a per-sub-block basis, by use of block size information about a size of a block output from the channel interleaver 12 (a block size) including information about the sub-block length. Operation of stream mapping will be described later.

The IFFT sections 15A and 15B perform processing for transforming streams into time-domain streams by means of subjecting the thus-generated streams 1 and 2 to IFFT (Inverted Fast Fourier Transform). The transmission RF sections 16A and 16B multiplex control information, a pilot signal, and others, on data symbols output from the IFFT sections 15A and 15B, thereby generating baseband signals; convert the baseband signals into RF signals through frequency conversion; and amplify transmission power of the RF signals, and the like. The antennas 17A and 17B emit RF transmission signals in the form of radio waves, thereby transmitting transmission signals of two streams. The IFFT sections 15A and 15B, the transmission RF sections 16A and 16B, and the antennas 17A and 17B implement a function of a transmitter.

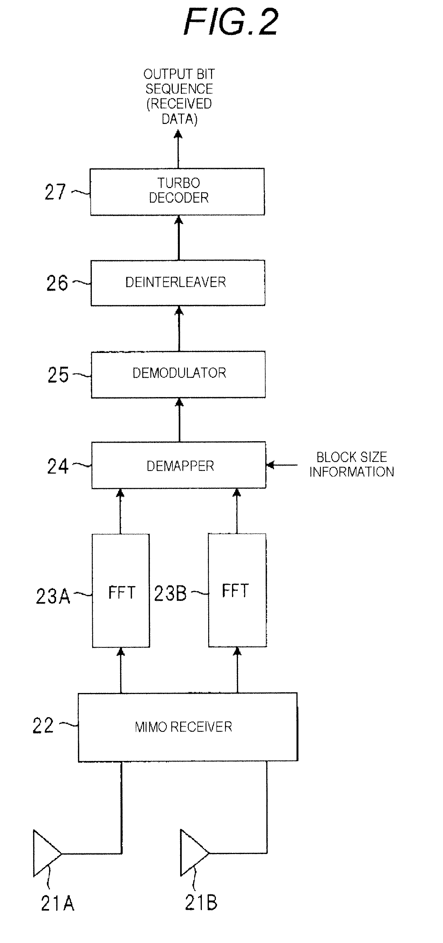

Fig. 2 is a block diagram showing an example configuration of a receiver of the wireless communication device according to the embodiment of the present invention. Fig. 2 shows an example configuration of a receiver compliant with the transmitter shown in Fig. 1, in which two antennas receive the two streams by means of MIMO receiving operation.

The receiver of the wireless communication device includes antennas 21A and 21B, a MIMO receiver 22, FFT sections 23A and 23B, a demapper 24, a demodulator 25, a deinterleaver 26, and a turbo decoder 27.

The antennas 21A and 21B receive the respective radio waves of the transmission signals, thereby acquiring received RF signals. The MIMO receiver 22 converts the RF signal into the baseband signal through frequency conversion; estimates a channel by use of a pilot signal; and performs MIMO demodulation on the basis of a result of channel estimation, thereby demodulating data symbols of two streams. The FFT sections 23A and 23B perform processing for transforming respective data symbols of the streams 1 and 2, which have been extracted by means of MIMO demodulation, into frequency-domain symbols by means of FFT (Fast Fourier Transform). The antennas 21A and 21B, the MIMO receiver 22, and the FFT sections 23A and 23B implement a function of a receiver.

The demapper 24 demaps the two streams 1 and 2, thereby generating a line of modulation symbol sequence modulated according to the 16QAM modulation scheme, or the like. The demapper 24 demaps a plurality of streams in response to stream mapping performed by the stream mapper 14 of the transmitter. Specifically, the demapper performs demapping by use of the block size information according to the stream mapping method modified for each predetermined unit commensurate with a block size; for instance, for each sub-block length, thereby reconstructing the original modulation symbol sequence. The demodulator 25 demodulates a modulation symbol sequence modulated by the 16QAM modulation scheme, or the like.

The deinterleaver 26 restores interlacing of the parity bits to the original and performs deinterleaving on a per-sub-block basis (sub-block deinterleaving), thereby reconstructing original encoded data. The turbo decoder 27 decodes the encoded data and outputs received data subjected to decoding as an output bit sequence.

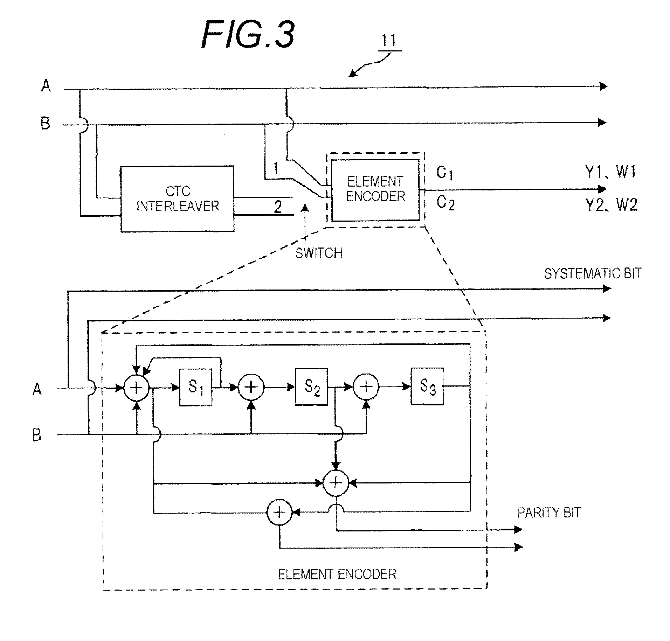

Fig. 3 is a schematic diagram showing a configuration and operation of the turbo encoder employed in the wireless communication device according to the present embodiment. The turbo encoder 11 shown in Fig. 3 is an encoder that is specified by the IEEE 802.16e standards and that is also used in the 802.16m standards. The turbo encoder 11 includes a CTC (Conventional Turbo Coding) interleaver, and an element encoder. Two systematic bit sequences A and B are input to the turbo encoder 11, where parity bit sequences Y1, Y2, W1 and W2, which are redundant data, are generated from the systematic bits A and B, and the thus-generated parity bit sequences are output. Since an encoding rate 1/3 is used as a mother code in the 802.16e and 802.16m standards, an output 3 including the systematic bits A and B + the parity bits Y1/Y2 and W1/W2 is output in response to an input 1 including the systematic bits A and B.

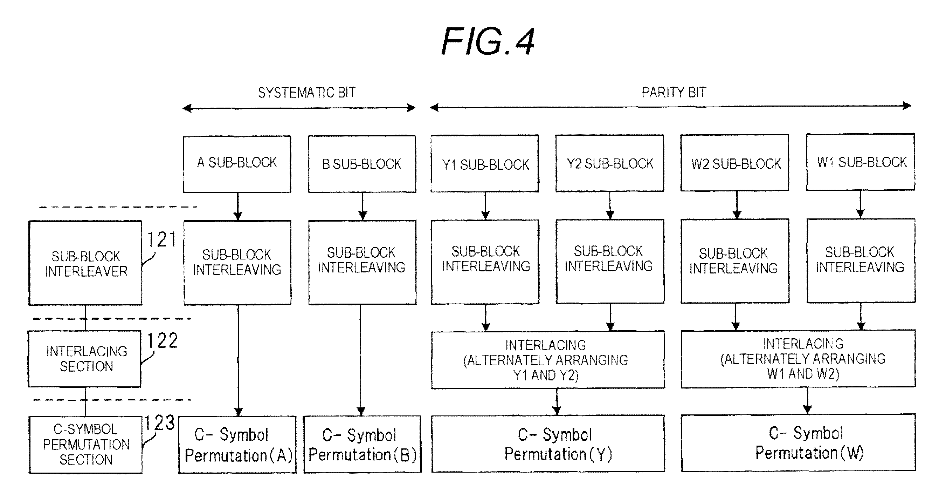

Fig. 4 is a diagram showing a configuration and operation of the channel interleaver of the wireless communication device according to the present embodiment.

The systematic bits A and B of the encoded data and the parity bits Y1, Y2, W1, and W2 are input to the channel interleaver 12 and handled as six sub-blocks respectively formed from the bit sequences. The channel interleaver 12 has a sub-block interleaver 121, an interlacing section 122, and a C-symbol permutation section 123.

In the channel interleaver 12, the sub-block interleaver 121 first subjects the systematic bits (the sub-blocks A and B) and the parity bits (the sub-blocks Y1, Y2, W1, and W2) to interleaving on a per-sub-block basis. A size of each of the sub-blocks corresponds to one sub-block length. All of the sub-blocks assume the same interleaving pattern. On this occasion, the order of parity bits is taken as Y1, Y2, W2, and W1, and the positions of the bits W1 and W2 are interchanged.

The interlacing section 122 subjects the parity bits Y1 and Y2 to interlacing for arraying the parity bits Y1 and Y2 by turns. Further, the interlacing section 122 subjects the parity bits W2 and W1 to interlacing for arraying the bits W2 and W1 by turns. The size of each of the interlaced blocks comes to a length of two sub-blocks. Subsequently, the C-symbol permutation section 123 subjects the respective blocks A, B, Y1/Y2, and W2/W1 to C-symbol permutation processing described in connection with the background art. On this occasion, an order of bits allocated to each of the symbols is changed by turns on a per-modulation symbol basis, such as Y1, Y2 → Y2, Y1 in correspondence with the size of the sub-blocks and a modulation multivalue number employed by the modulator 13 (specifically, the number of bits of a modulation symbol). The same also applies to the parity bits W1 and W2. In each of the blocks subjected to channel interleaving, a disparity in a degree of reliability between bits with respect to symbol mapping that arise when the bits are subjected to multilevel modulation is lessened by C-symbol permutation.

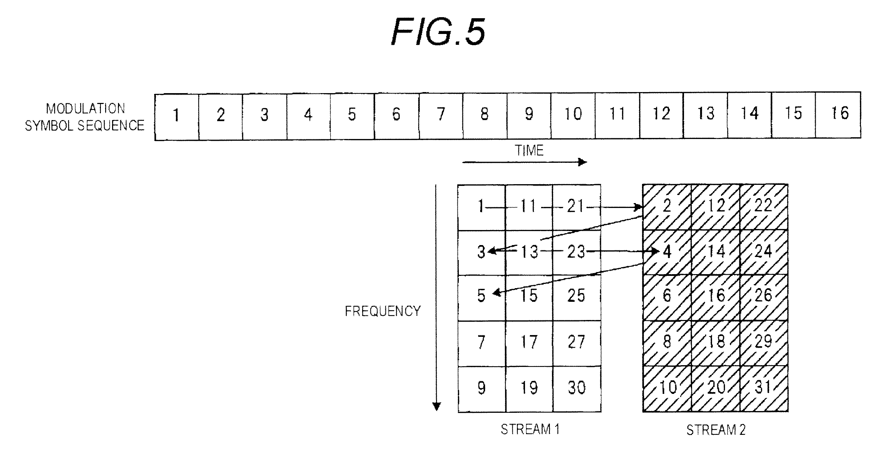

Fig. 5 is a diagram for describing operation of the stream mapper in the wireless communication device according to the present embodiment. The stream mapper 14 maps, by turns, streams in directions of the antennas, such as the stream 1 and the stream 2, in relation to the modulated modulation symbol sequence and also performs mapping in each of the streams in terms of and also in an order of a frequency and a time. By means of stream mapping, the modulation symbol sequence is uniformly allocated in each of the resources, such as streams, frequencies, and times, whereby a disparity between symbols is lessened for each of the plurality of streams.

In the present embodiment, when stream mapping and C-symbol permutation are combined together, the stream mapper 14 changes the stream mapping method in order to diminish a chance of the same stream signals continually appearing in deinterleaved data and lessen a disparity in stream mapping. Specifically, the order of streams to be mapped is changed on each unit commensurate with the block size, by use of the block size information, thereby preventing bits of the same stream from continually appearing in a bit array achieved after deinterleaving as much as possible. The parity bits Y1 and Y2 are exemplified in the following descriptions. However, the same also applies to the parity bits W1 and W2 and the systematic bits A and B. In the case of the systematic bits A and B, the block size of the bit sequence is reduced to the half.

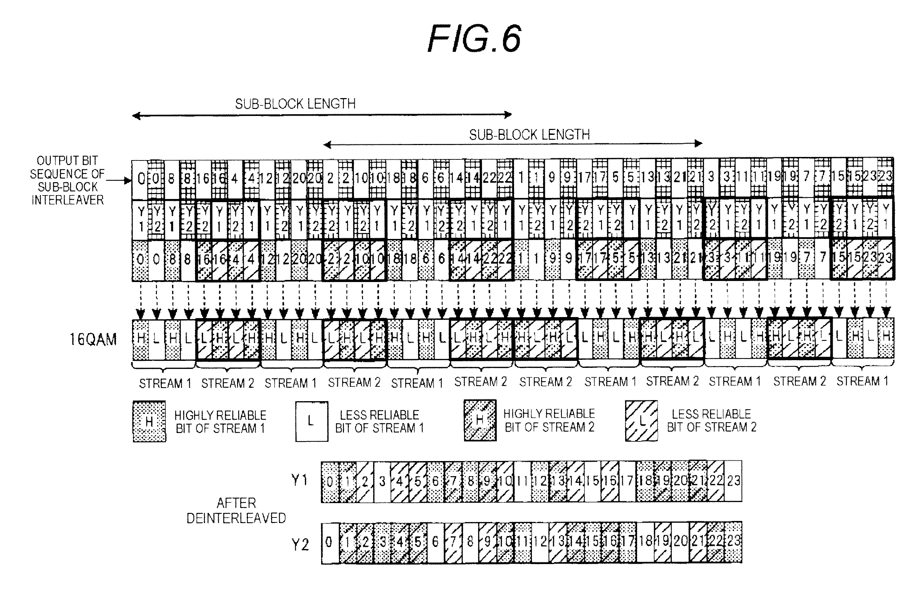

By reference to Figs. 6 through 8, example stream mapping operation according to the embodiment is now described. These drawings show operation of the channel interleaver 12, the modulator 13, and the stream mapper 14.

Fig. 6 is a diagram showing first example stream mapping (performed for 16QAM multilevel modulation) according to the present embodiment. The first example shown in Fig. 6 shows a relationship between stream mapping performed by the transmission end and an array of deinterleaved bits achieved at the receiving end when two streams are transmitted by use of 16QAM modulation as a modulation scheme. The stream mapper 14 changes an order of stream mapping at a length of each sub-block, such as an order of the stream 1 → the stream 2 and another order of the stream 2 → the stream 1.

Fig. 6 shows bit sequences achieved after sub-block interleaving and interlacing, an array of modulation symbols, and mapping of streams, all of which pertain to the parity bits Y1 and Y2. The first top row in Fig. 6 shows an array of bit sequences subjected to sub-block interleaving and interlacing. The order of arrangement of indices of the respective bits is interchanged by means of sub-block interleaving. The indices are numerals that start from zero and that are sequentially affixed, in an ascending order from a start bit, to respective bits one by one for each of sub-blocks in a bit sequence that is not yet subjected to sub-block interleaving. The second row shows arrays of respective sub-blocks Y1 and Y2. The parity bits Y1 and Y2 are arrayed by turns by means of interlacing, and an entirety of a block Y1/Y2 to be output makes up a bit sequence that equal in length to two sub-blocks.

The third row shows a difference in a degree of reliability of respective bits achieved after 16QAM modulation, and a fourth row shows stream mapping caused by 16QAM modulation. Four bits are subjected one at a time as one symbol, in sequence from the first bit, to 16 QAM modulation. (Dot-hatched) reference symbols "H" in the drawing denote highly reliable bits, whilst (unhatched) reference symbols "L" denote less reliable bits. An order of allocation of the parity bits Y1 and Y2 is changed for each modulation symbol by application of C-symbol permutation, whereupon the difference in degree of reliability between the parity bits Y1 and Y2 is interchanged. Further, modulation symbols are sequentially mapped by turns such as a stream 1 and a stream 2. Streams having slanted hatches in the drawings denote the streams 2, and streams not having slanted hatches denote the streams 1. The bottom row shows arrays of the deinterleaved parity bits Y1 and Y2 reconstructed at the receiving end as a result of streams having been subjected to demapping, demodulation, and channel deinterleaving.

When the bit sequence subjected to sub-block interleaving and interlacing is observed at the channel interleaver 12, even indices are arrayed in a first half of the bit sequence, and odd indices are arrayed in a second half of the bit sequence. Adjacent indices (e.g., 0 and 1, and 2 and 3) are separated from each other by a length of one sub-block. Accordingly, the stream mapper 14 changes the order of stream mapping at a position spaced from the start of a bit sequence by the length of one sub-block; namely, a position of a half of a bit sequence of a block Y1/Y2 having a length equal to the length of two sub-blocks, whereby streams are changed at adjacent indices. In the example shown in Fig. 6, attention is paid to an index of one adjacent to a start index of zero in a bit sequence that is not yet subjected to sub-block interleaving, and an order of stream mapping is changed at a position where the index of one appears after the bit sequence has undergone sub-block interleaving. The channel interleaver 12 according to the present embodiment has a characteristic that a bit of the next index always comes to a position of a half of the length of the bit sequence having undergone sub-block interleaving. Accordingly, by utilization of the characteristic, stream mapping is changed at the position of the half of a bit sequence of a block Y1/Y2 having a length equal to the length of two sub-blocks.

As a result, since streams are switched at adjacent indices of respective sub-blocks, a disparity in stream mapping can be eliminated. In the respective bit sequences Y1 and Y2 deinterleaved by the deinterleaver 26 at the receiving end, a length over which the same streams are continually arrayed becomes shorter. Further, since only a maximum of two bits of the same stream continually appears, a probability that error correction capability can be exhibited can be enhanced.

The essential requirements for the systematic bits A and B in the first example are that an order of stream mapping should be changed at a position of a half of a bit sequence of each of the sub-blocks; namely, a position corresponding to a half of the sub-block.

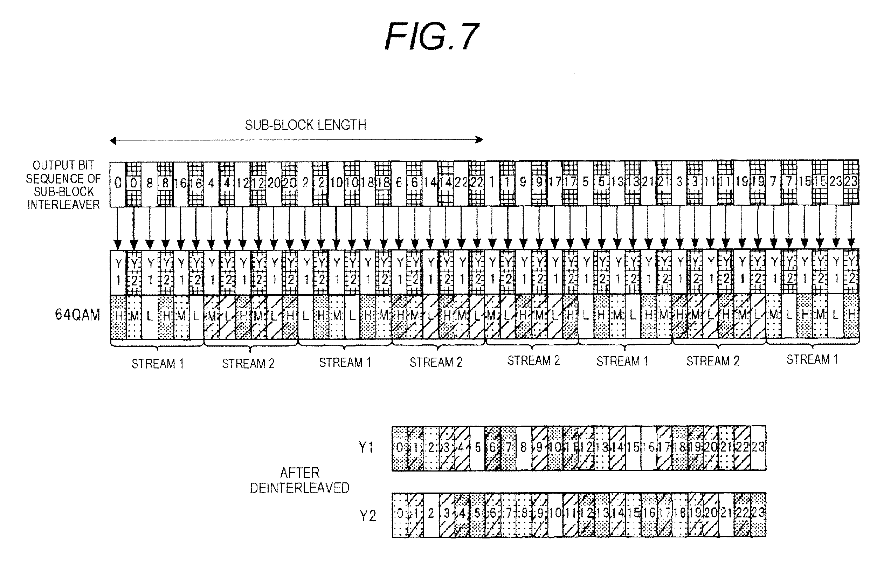

Fig. 7 is a diagram showing second example stream mapping (performed for 64QAM multilevel modulation) according to the present embodiment. A second example shown in Fig. 7 shows a relationship between stream mapping performed at the transmission end and an array of bits achieved after deinterleaving at the receiving end when two streams are transmitted by use of 64QAM modulation as a modulation scheme, in much the same way as the example shown in Fig. 6. The stream mapper 14 changes an order of stream mapping for a length of each sub-block, such as an order of the stream 1 → the stream 2 and another order of the stream 2 → the stream 1.

Stream mapping of the stream mapper 14 depends on a characteristic and operation of the channel interleaver 12, and hence similar processing is performed even when the modulation scheme has changed. In Fig. 7, reference symbol "H" depicts highly reliable bits; reference symbol "M" depicts bits having a medium degree of reliability; and "L" depicts less reliable bits. The order of allocation of the bits Y1 and Y2 is changed at each modulation symbol by application of C-symbol permutation, whereupon the degree of reliability of the bits Y1 and Y2 is interchanged among a high degree of reliability, a medium degree of reliability, and a low degree of reliability. When the stream mapper 14 sequentially maps the modulation symbols, such as the stream 1 and the stream 2, the order of stream mapping is changed at a position separated from the start bit of the bit sequence by the length of one sub-block; namely, a position of a half of the bit sequence of the block Y1/Y2 having a length equal to the length of two sub-blocks. Streams having slanted hatches in the drawings depict the streams 2, whilst streams not having slanted hatches depict the streams 1.

Since the streams are changed at adjacent indices of the respective sub-blocks as in the first embodiment, the chance of bits of the same streams continually appearing in the respective deinterleaved bit sequences Y1 and Y2 can be lessened, so that error correction capability can be sufficiently exhibited.

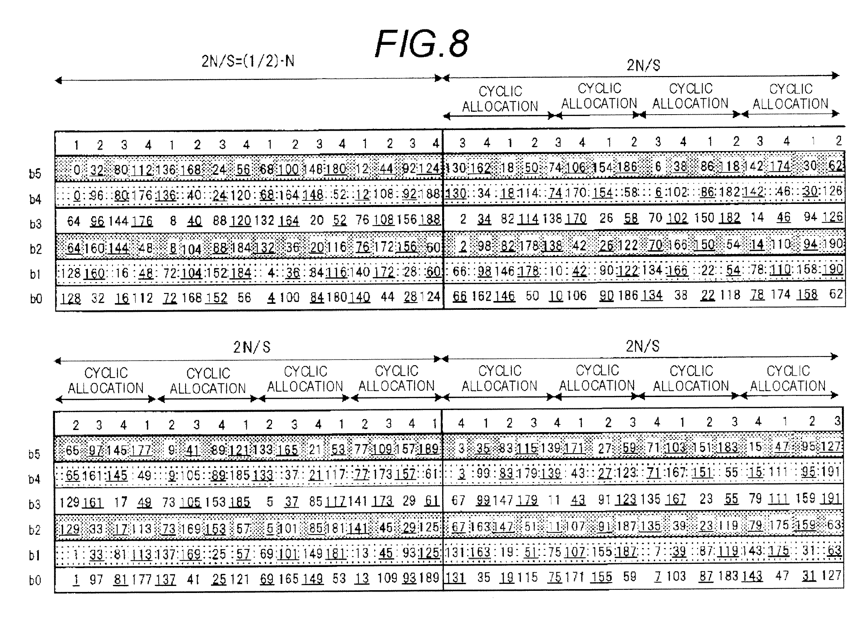

Fig. 8 is a diagram showing third example stream mapping (when four streams are transmitted by use of 64QAM multilevel modulation). A third example shown in Fig. 8 shows stream mapping performed when four streams are transmitted by use of 64QAM modulation as a modulation scheme. The stream mapper 14 changes the order of stream mapping for each length of a half sub-block (a half of the length of sub-block) such as an order of the stream 1 → the stream 2 → the stream 3 → the stream 4 and an order of the stream 3 → the stream 4 → the stream 1 → the stream 2.

Fig. 8 shows bit sequences of an overall block, an array of modulation symbols, and stream mapping achieved after the parity bits Y1 and Y2 having been subjected to sub-block interleaving, interlacing, and C-symbol permutation as stream mapping. An upper row of Fig. 8 shows a first half of the block, whilst a lower row of the same shows a second half of the block. Fig. 8 shows the bit sequences in a two-dimensional manner. One box denotes each of bits, and an upper left end bit is taken as a start bit. The bits are sequentially arrayed from top to bottom and from left to right. Numerals of the respective bits denote respective indices. Non-underlined indices are assumed to denote Y1, and underlined indices are assumed to denote Y2. Further, vertically aligned bits b0 to b5 denote allocation of bits of 64QAM modulation symbols. Numerals 1 through 4 in the first row denote stream numbers, respectively. Hatches of the respective boxes depict degrees of reliability of respective modulated bits. Specifically, small dotted hatches depict bits having a high degree of reliability; roughly dotted hatches depict bits having a medium degree of reliability, and bits not having hatches depict bits having a low degree of reliability.

When mapping the modulation symbols in order of the stream 1, the stream 2, the stream 3, and the stream 4, the stream mapper 14 changes the order of stream mapping at a position that is distance from the start of the bit sequence by a length of a half sub-block. In the embodiment shown in Fig. 8, attention is paid to the fact that indices 1, 2, and 3 of the bit sequences adjacent to a start bit 0. The order of stream mapping is changed at positions of indices 2, 1, and 3 after the parity bits have been subjected to sub-block interleaving. On this occasion, streams to be mapped in an order of 1, 2, 3, 4 → 3, 4, 1, 2 → 2, 3, 4, 1 → 4, 1, 2, 3 are cyclically shifted and allocated to the symbols of change points.

The streams are thereby changed at adjacent indices of the respective sub-blocks as in the first and second examples. Hence, the chance of bits of the same streams continually appearing in the respective deinterleaved bit sequences Y1 and Y2 can be lessened, so that error correction capability can be sufficiently exhibited.

A general expression is provided in connection with a change in stream mapping made by the stream mapper 14. The number of streams to be transmitted is taken as S, and the size (a length of each sub-block) of a sub-block to be subjected to sub-block interleaving is taken as N. In relation to the interleaved parity bits, the block size of the block Y1/Y2 is 2N. Therefore, in the case of a stream S, the stream mapping method is changed at a position of a 2N/Sth bit from the start of the bit sequence of the block. A block size of each of the sub-blocks A, B, Y1, Y2, W1, and W2 is N, and a block size of each of the interlaced parity bits Y1/Y2 and W1/W2 is 2N. Consequently, in relation to the parity bits Y1/Y2 and W1/W2, each of the bit sequences assumes a block size 2N and the number of streams S. From them, the stream mapping method is changed at a position of 2N/S. In relation to the systematic bits A and B, the stream mapping method is changed at the position of the bit N/S on account of the block size N and the number of streams S assumed by each of the bit sequences.

When the block size of each of the blocks A, B, Y1/Y2, and W1/W2 output from the channel interleaver 12 is taken as K, the essential requirement is to change the stream mapping method at each position of K/S from the start of each of the blocks. In the case of the parity bits Y1/Y2 and W1/W2, the block size comes to K=2N. In the case of the systematic bits A and B, the block size comes to K=N.

Specifically, the stream mapping method involves changing the order of streams by means of which the modulation symbols are mapped. At this time, a symbol of a change point is mapped to a stream of the "minimum index + 1" by use of a value of the minimum index, among the symbols of the change points, and subsequent symbols are cyclically allocated by an amount equal to S streams. In subsequent operation, a change is made to the stream mapping method for each position of 2N/S (or N/S) in the same manner as mentioned above. In this case, numbers of streams to be mapped are cyclically shifted according to the minimum index among the symbols of the change points.

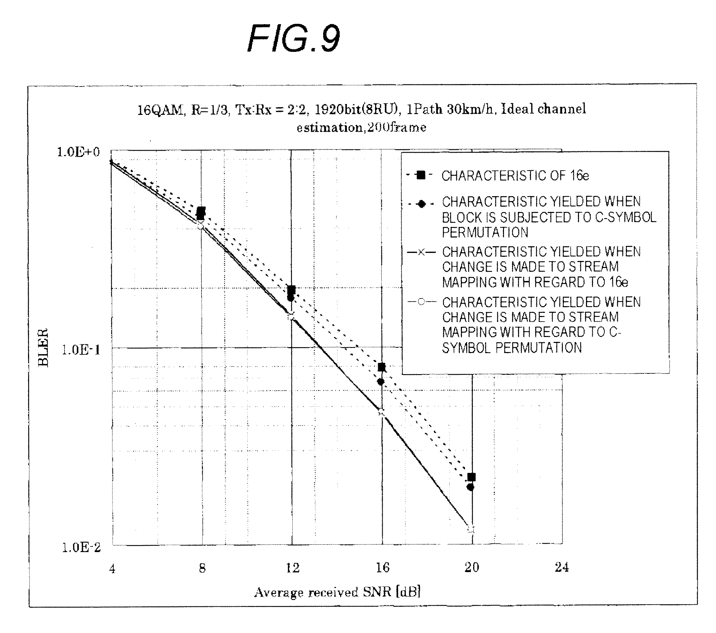

Fig. 9 is a characteristic graph showing an example simulation result yielded when stream mapping according to the present embodiment is used. Fig. 9 shows a relationship between an average received SNR (Signal to Noise Ratio) and a block error rate (BLER) achieved when 16QAM is used as a modulation scheme and when a mother coding ratio R=1/3 is employed. (1) a characteristic yielded by stream mapping conforming to the IEEE802.16e standards is represented by a solid square symbol "■"; (2) a characteristic yielded when the block is subjected to C-symbol permutation with respect to (1) is represented by a solid circular symbols "•"; (3) a characteristic yielded when a change is made to stream mapping according to the present embodiment with regard to the standards 802.16e described in connection with (1) is represented by a cross symbol "x"; and (4) a characteristic yielded when a change is made to stream mapping according to the present embodiment with regard to C-symbol permutation described in connection with (2) is represented by a circle symbol ○.

As mentioned above, the stream mapping method has been changed for each predetermined unit commensurate with a block size, such as the length of each sub-block, whereby there is obtained a simulation result showing that a characteristic relating to an error rate, such as a BLER, is enhanced. An example simulation result shown in Fig. 9 shows that an advantage yielded by the change in stream mapping according to the embodiment is great.

As mentioned above, in the present embodiment, the stream mapping method is changed on each predetermined unit commensurate with a block size; for instance, the length of each sub-block, while the configuration of the stream mapper is maintained. It is thereby possible to lessen the chance of the same streams continually appearing in the array of deinterleaved bits, so that error correction capability achieved after demodulation can be sufficiently exhibited. Even when a disparity in the degree of reliability in allocation of bits to modulation symbols for multilevel modulation is lessened at this time by combination of stream mapping with C-symbol permutation, it is possible to prevent the bits of the same streams in the array of deinterleaved bits from continually appearing longwise. Specifically, it is possible to prevent occurrence of a disparity in reliability of bits in transmission data and continual appearance of the same streams, which would otherwise arise when channel interleaving including sub-block interleaving, modulation, and stream mapping are performed. A disparity in symbol mapping and stream mapping developing when modulation data are transmitted by means of a plurality of streams can thereby be lessened, so that performance deterioration, such as deterioration of receiving performance due to degradation of a characteristic of a transmission channel, can be lessened.

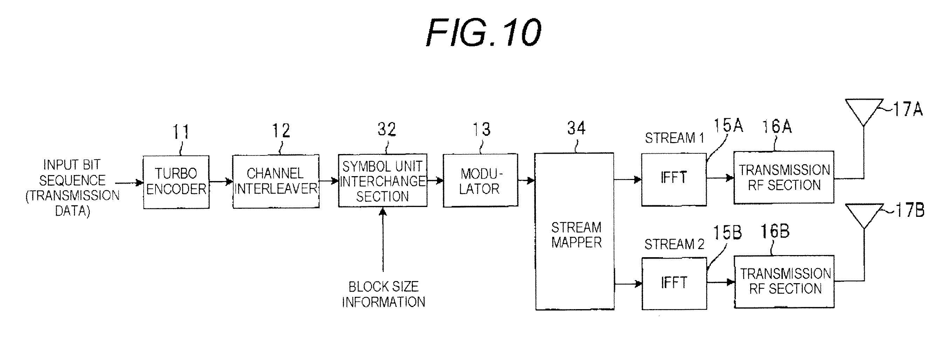

An example configuration and operation that yield an advantage equal to that yielded by the embodiment is illustrated as another embodiment. Fig. 10 is a block diagram showing an example configuration of a transmitter of a wireless communication device of another embodiment of the present invention.

A transmitter of the wireless communication device shown in Fig. 10 has a symbol unit interchange section 32 placed at a stage subsequent to the channel interleaver 12. A stream mapper 34 alternately maps the modulated modulation symbol sequences along the directions of the antennas without making a change to the order of stream mapping for each predetermined unit commensurate with the block size, while maintaining the order of stream mapping. Instead, the symbol unit interchange section 32 interchanges an array of yet-to-be-modulated bits on a per-modulation-symbol basis for each block, such as the blocks A, B, Y1/Y2, and W1/W2 output from the channel interleaver 12. On this occasion, the symbol unit interchange section 32 interchanges an array of the yet-to-be-modulated bits on a per-modulation-symbol basis at a change point for each predetermined unit commensurate with the block size, such as the length of each sub-block, by use of block size information (e.g., the length of each sub-block, and the like) pertaining to the output from the block size of the channel interleaver 12. In other respects, the wireless communication device according to the present embodiment is analogous to that shown in Fig. 1 and described in connection with the first embodiment in terms of a configuration and operation. When the transmitter is in the course of interchanging symbol unit bits, the receiver performs, at the deinterleaver or a stage preceding the deinterleaver, processing for restoring the bits interchanged on a per-symbol basis conforming to the block size to the original sequence.

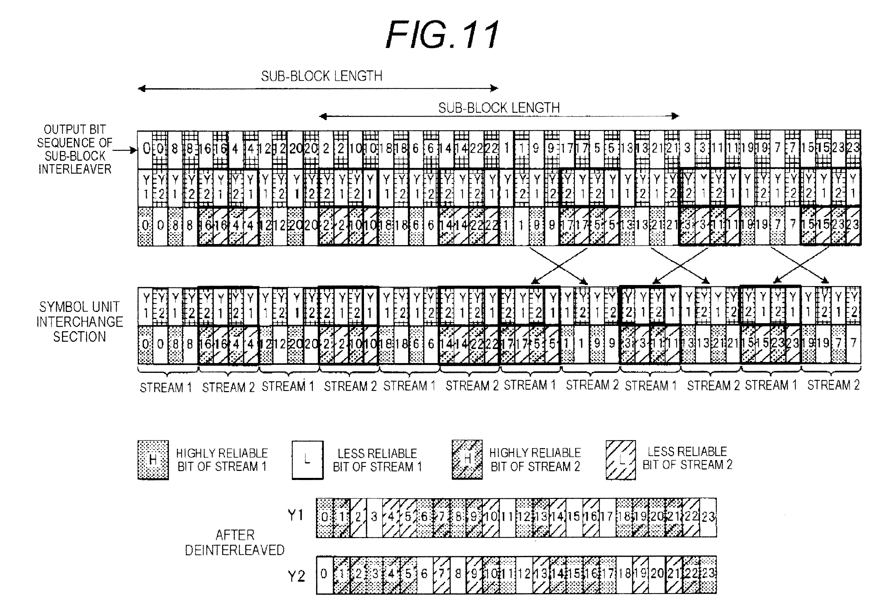

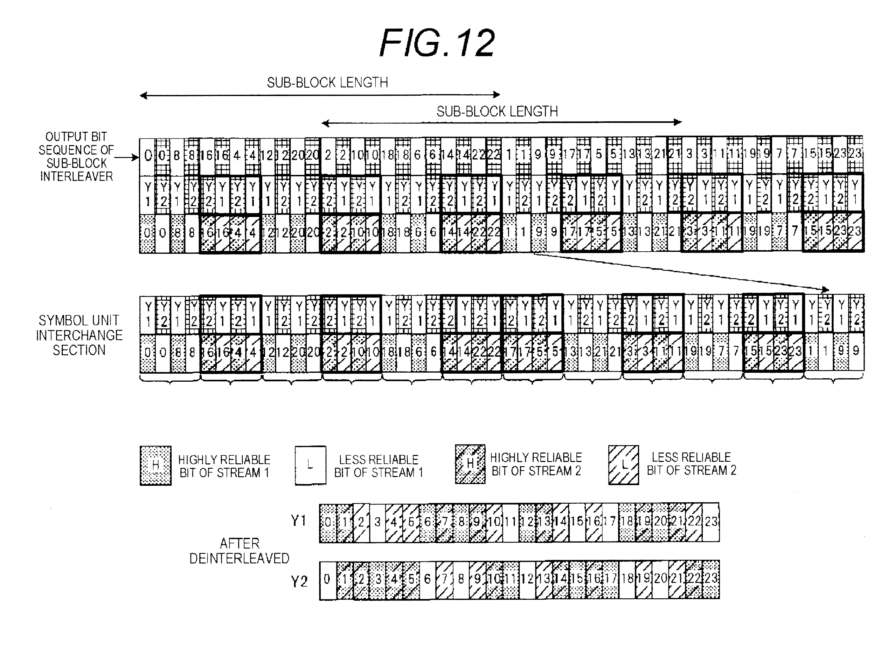

Example symbol unit bit interchange operation according to the present embodiment is described by reference to Figs. 11 and 12. The drawings show operation of the channel interleaver 12, operation of the symbol unit interchange section 32, operation of the modulator 13, and operation of the stream mapper 34.

Fig. 11 is a diagram showing first example bit interchange operation performed on a per-symbol basis according to the present embodiment. The first example shown in Fig. 11 shows a relationship between symbol unit bit interchange and stream mapping performed by the transmitter and an array of deinterleaved bits achieved by the receiving end when two streams are transmitted by use of 16QAM as a modulation scheme. The symbol unit interchange section 32 interchanges an order of adjacent four bits in symbol units (four bits in the case of 16QAM) according to a position equal to a change point of street mapping of the example shown in Fig. 6; namely, a position for the length of each sub-block in the illustrated example. The stream mapper 34 alternately maps the modulated modulation symbol sequences, such as the stream 1 → the stream 2. As a result, the transmission signal identical with that produced when a change is made to the order of stream mapping by means of the stream mapper is produced without interchanging the order of stream mapping.

Fig. 12 is a diagram showing second example bit interchange operation performed on a per-symbol basis according to the present embodiment. A second example shown in Fig. 12 corresponds to a modification of the first example shown in Fig. 11. The symbol unit interchange section 32 interchanges the symbol unit bits by means of cyclically shifting symbol unit bits, which are equal to a first symbol, backwards in connection with the bit sequence starting from the position of the same change point as that shown in Fig. 11 to the next change point. An advantage equal to that yielded when a change is made to stream mapping is thereby yielded as in the first embodiment. In this case, the order of transmission bits is changed. Various example modifications; for instance, a case where 64QAM modulation is used as the modulation scheme and where the number of streams is set to four, are available as in the same way as a change to stream mapping.

As mentioned above, operation for interchanging symbol unit bits includes interchanging an array of yet-to-be-modulated bits on a per-symbol basis in predetermined unit commensurate with a block size; for instance, the length of each sub-block, while the configuration of the stream mapper and the order of stream mapping are maintained. As a result, it is possible to lessen the chance of the same streams continually appearing in the array of deinterleaved bits, in the same manner as in the case where a change is made to stream mapping, so that demodulated error correction capability can be sufficiently exhibited.

The present invention is also expected to be subjected to various alterations or applications contrived by the person skilled in the art on the basis of descriptions of the specification and the well-known techniques without departing the spirit and scope of the present invention, and the alterations and applications shall also fall within a range where protection of the present invention is sought. Although the embodiments show a case where multilevel modulation, such as 16QAM and 64QAM, is used, the present invention can also be applied to another modulation scheme, such as QPSK.

Although the descriptions have been provided in the embodiments while the present invention is applied to the antenna, the present invention can likewise be applied to an antenna port, too. The word "antenna port" denotes a logical antenna port built from one or a plurality of physical antennas. Specifically, the antenna port does not always denote one physical antenna and may sometimes designate an arrayed antenna, or the like, built from a plurality of antennas. For instance, in LTE, the number of physical antennas making up the antenna port is not specified. The antenna port is defined as a minimum unit that enables a base station to transmit different reference signals. Further, the antenna port is sometimes specified as a minimum unit at which weighting on a precoding vector is multiplied.

Although the present invention has been described in the embodiments by means of taking as an example a case where the present invention is implemented by hardware, the present invention can also be implemented by means of software.

Respective function blocks used for describing the present embodiments are implemented as an LSI that is typically an integrated circuit. These blocks can also be implemented in the form of single chips, respectively. Alternatively, the function blocks can also be implemented as a single chip that includes some or all of the functions. Although the LSI is mentioned, integration of the function blocks can also be called an IC, a system LSI, a super-LSI, or an ultra-LSI according to a degree of integration.

The technique for integrating the function blocks into circuitry is not limited to LSI technology, and the function blocks can also be implemented by means of a custom-designed circuit or a general-purpose processor. Further, an FPGA (Field Programmable Gate Array) capable of being programmed after manufacture of an LSI and a reconfigurable processor whose connections or settings of circuit cells in an LSI can be reconfigured can also be utilized.

Further, if a technique for integrating function blocks into circuits replaceable with the LSI technology by virtue of advancement of the semiconductor technology or another technique derived from advancement of the semiconductor technology has emerged, the function blocks can naturally be integrated by use of the technique. Adaption of biotechnology is feasible.

The present application is based on Japanese Patent Application (No. 2009-106566) filed on April 24, 2009, the entire subject matter of which is incorporated herein by reference.

Industrial Applicability

The present invention yields an advantage of making it possible to lessen a disparity in stream mapping of transmission data when modulation data are mapped into a plurality of streams and when the plurality of streams are transmitted and received. The present invention is useful as a wireless communication device and method, or the like, applicable to a wireless communication system that transmits a plurality of streams; for instance, a wireless communication system conforming to IEEE 802.16m or the like.

Reference Signs List

11 TURBO ENCODER
12 CHANNEL INTERLEAVER
13 MODULATOR
14 STREAM MAPPER
15A, 15B IFFT SECTION
16A, 16B TRANSMISSION RF SECTION
17A, 17B ANTENNA
21A, 21B ANTENNA
22 MIMO RECEIVER
23A, 23B FFT SECTION
24 DEMAPPER
25 DEMODULATOR
26 DEINTERLEAVER
27 TURBO DECODER

**Claims**

1. A wireless communication device to be used in a wireless communication system for transmitting a plurality of streams, the wireless communication device comprising:

an encoder that is configured to encode a bit sequence to be transmitted;
a channel interleaver that includes a sub-block interleaver for subjecting encoded data to sub-block interleaving on a per-sub-block basis;
a modulator that is configured to generate a modulation symbol sequence from a bit sequence output from the channel interleaver;
a stream mapper that is configured to map the modulation symbol sequence to a plurality of streams; and
a transmitter that is configured to transmit the plurality of streams, wherein
the stream mapper is configured to sequentially map the modulation symbol sequence to the plurality of streams in each block output from the channel interleaver and to change a stream mapping method in each predetermined unit corresponding to a block size of the block.

2. The wireless communication device according to claim 1, wherein
the encoder is configured to generate bit sequences of parity bits in two sub-blocks in response to systematic bits in one sub-block input as the bit sequence,
the channel interleaver further includes an interlacing section that is configured to subject the two sub-blocks to interlacing after the sub-block interleaving with regard to the parity bits of the encoded data, and
the stream mapper is configured to employ as the block size a sub-block length representing a length of the sub-block, and changes an order of stream mapping at each position of $2N/S$ with regard to the block of the parity bits, where the sub-block length is taken as N and where the number of streams is taken as S.

3. The wireless communication device according to claim 2, wherein

the stream mapper alternately changes the order of stream mapping on 1 sub-block length basis with regard to the block of the parity bits when two streams are to be transmitted as the plurality of streams.

4. The wireless communication device according to claim 2, wherein
the stream mapper changes the order of stream mapping at each position of N/S with regard to the block of the systematic bits.

5. The wireless communication device according to claim 4, wherein
the stream mapper alternately changes the order of stream mapping on half sub-block length basis with regard to the block of the systematic bits when two streams are to be transmitted as the plurality of streams.

6. The wireless communication device according to claim 2, wherein
the channel interleaver further includes a C-symbol permutation section that subjects each of the blocks, which is sub-block interleaved or is sub-block interleaved and interlaced, to C-symbol permutation processing for changing an order of bits to be allocated to respective symbols for each modulation symbol in the modulator.

7. The wireless communication device according to claim 1, wherein
the stream mapper changes the stream mapping method at each position of K/S from a beginning of each of the blocks where the block size is taken as K and where the number of streams is taken as S.

8. The wireless communication device according to claim 1, wherein
the stream mapper cyclically shifts an order of allocation of streams when changing the stream mapping method.

9. The wireless communication device according to claim 1, wherein
the modulator performs modulation complying with any one of QPSK, 16QAM, and 64QAM schemes.

10. A wireless communication device to be used in a wireless communication system for transmitting a plurality of streams, the wireless communication device comprising:

a receiver that is configured to receive a plurality of streams;
a demapper that is configured to perform demapping in response to stream mapping to which the plurality of received streams have been subjected, to generate a modulation symbol sequence from the plurality of received streams;
a demodulator that is configured to demodulate the modulation symbol sequence;
a deinterleaver that includes a sub-block deinterleaver for subjecting the demodulated bit sequence to sub-block deinterleaving on a per-sub-block basis to reconstruct original encoded data; and
a decoder that is configured to decode the encoded data, wherein
the demapper is configured to perform demapping according to a block size of a block, which is output from a channel interleaver in a transmitter that has transmitted the plurality of streams, when a stream mapping method is changed in each predetermined unit corresponding to the block size in the stream mapping.

11. A wireless communication method in a wireless communication system for transmitting a plurality of streams, the wireless communication method comprising the steps of:

encoding a bit sequence to be transmitted;
subjecting encoded data to channel interleaving including sub-block interleaving to be performed on a per-sub-block basis;
generating a modulation symbol sequence from the channel-interleaved bit sequence;
mapping the modulation symbol sequence to a plurality of streams; and
transmitting the plurality of streams, wherein
the step of mapping the modulation symbol sequence into the plurality of streams includes sequentially mapping the modulation symbol sequence to the plurality of streams in each block after channel interleaving and changing a stream mapping method in each predetermined unit corresponding to a block size of the block.

12. A wireless communication method in a wireless communication system for transmitting a plurality of streams, the wireless communication method comprising the steps of:

receiving a plurality of streams;

performing demapping in response to stream mapping to which the plurality of received streams have been subjected, to generate a modulation symbol sequence from the plurality of received streams;
demodulating the modulation symbol sequence;
reconstructing original encoded data by subjecting the demodulated bit sequence to deinterleaving by a sub-block deinterleaving on a per-sub-block basis; and
decoding the encoded data, wherein
the step of performing demapping includes performing demapping according to a block size of a block which is interleaved in a transmitter that has transmitted the plurality of streams, when a stream mapping method is changed in each predetermined unit corresponding to the block size in the stream mapping.

# FIG.1

INPUT BIT SEQUENCE (TRANSMISSION DATA) → [11 TURBO ENCODER] → [12 CHANNEL INTERLEAVER] → [13 MODULATOR] → [14 STREAM MAPPER]

STREAM 1 → [15A IFFT] → [16A TRANSMISSION RF SECTION] → 17A

STREAM 2 → [15B IFFT] → [16B TRANSMISSION RF SECTION] → 17B

BLOCK SIZE INFORMATION

EP 2 424 143 A1

# FIG.2

OUTPUT BIT
SEQUENCE
(RECEIVED
DATA)

27 — TURBO DECODER

26 — DEINTERLEAVER

25 — DEMODULATOR

24 — DEMAPPER ← BLOCK SIZE INFORMATION

23A — FFT    23B — FFT

22 — MIMO RECEIVER

21A        21B

# FIG.3

SWITCH

SYSTEMATIC BIT

PARITY BIT

ELEMENT ENCODER

EP 2 424 143 A1

## FIG.4

SYSTEMATIC BIT                                    PARITY BIT

| A SUB-BLOCK | B SUB-BLOCK | Y1 SUB-BLOCK | Y2 SUB-BLOCK | W2 SUB-BLOCK | W1 SUB-BLOCK |

SUB-BLOCK INTERLEAVER  121

| SUB-BLOCK INTERLEAVING | SUB-BLOCK INTERLEAVING | SUB-BLOCK INTERLEAVING | SUB-BLOCK INTERLEAVING | SUB-BLOCK INTERLEAVING | SUB-BLOCK INTERLEAVING |

INTERLACING SECTION  122

INTERLACING (ALTERNATELY ARRANGING Y1 AND Y2)

INTERLACING (ALTERNATELY ARRANGING W1 AND W2)

C-SYMBOL PERMUTATION SECTION  123

| C− Symbol Permutation(A) | C− Symbol Permutation(B) | C− Symbol Permutation(Y) | C− Symbol Permutation(W) |

# FIG.5

MODULATION SYMBOL SEQUENCE

| 1 | 2 | 3 | 4 | 5 | 6 | 7 | 8 | 9 | 10 | 11 | 12 | 13 | 14 | 15 | 16 |

TIME →

FREQUENCY

| 1—11—21 | 2 | 12 | 22 |
| 3—13—23 | 4 | 14 | 24 |
| 5 | 15 | 25 | 6 | 16 | 26 |
| 7 | 17 | 27 | 8 | 18 | 29 |
| 9 | 19 | 30 | 10 | 20 | 31 |

STREAM 1          STREAM 2

EP 2 424 143 A1

19

# FIG.6

SUB-BLOCK LENGTH

SUB-BLOCK LENGTH

OUTPUT BIT
SEQUENCE OF
SUB-BLOCK
INTERLEAVER

16QAM

STREAM 1  STREAM 2  STREAM 1  STREAM 2  STREAM 1  STREAM 2  STREAM 2  STREAM 1  STREAM 2  STREAM 1  STREAM 2  STREAM 1

| H | HIGHLY RELIABLE BIT OF STREAM 1 | L | LESS RELIABLE BIT OF STREAM 1 | H | HIGHLY RELIABLE BIT OF STREAM 2 | L | LESS RELIABLE BIT OF STREAM 2 |

Y1

AFTER
DEINTERLEAVED

Y2

EP 2 424 143 A1

# FIG.7

SUB-BLOCK LENGTH

OUTPUT BIT
SEQUENCE OF
SUB-BLOCK
INTERLEAVER

64QAM

STREAM 1   STREAM 2   STREAM 1   STREAM 2   STREAM 2   STREAM 1   STREAM 2   STREAM 1

AFTER
DEINTERLEAVED

Y1

Y2

*FIG.8*

# FIG.9

16QAM, R=1/3, Tx:Rx = 2:2, 1920bit(8RU), 1Path 30km/h, Ideal channel estimation,200frame

Legend:
- ■ CHARACTERISTIC OF 16e
- ◆ CHARACTERISTIC YIELDED WHEN BLOCK IS SUBJECTED TO C-SYMBOL PERMUTATION
- —×— CHARACTERISTIC YIELDED WHEN CHANGE IS MADE TO STREAM MAPPING WITH REGARD TO 16e
- —○— CHARACTERISTIC YIELDED WHEN CHANGE IS MADE TO STREAM MAPPING WITH REGARD TO C-SYMBOL PERMUTATION

Y-axis: BLER (1.0E+0, 1.0E-1, 1.0E-2)

X-axis: Average received SNR [dB] (4, 8, 12, 16, 20, 24)

FIG.10

# FIG.11

SUB-BLOCK LENGTH

SUB-BLOCK LENGTH

OUTPUT BIT SEQUENCE OF SUB-BLOCK INTERLEAVER

SYMBOL UNIT INTERCHANGE SECTION

STREAM 1　STREAM 2　STREAM 1　STREAM 2　STREAM 1　STREAM 2　STREAM 1　STREAM 2　STREAM 1　STREAM 2　STREAM 1　STREAM 2

HIGHLY RELIABLE BIT OF STREAM 1

LESS RELIABLE BIT OF STREAM 1

HIGHLY RELIABLE BIT OF STREAM 2

LESS RELIABLE BIT OF STREAM 2

AFTER DEINTERLEAVED

Y1

Y2

EP 2 424 143 A1

# FIG.12

SUB-BLOCK LENGTH

SUB-BLOCK LENGTH

OUTPUT BIT
SEQUENCE OF
SUB-BLOCK
INTERLEAVER

SYMBOL UNIT
INTERCHANGE
SECTION

HIGHLY RELIABLE
BIT OF STREAM 1

LESS RELIABLE
BIT OF STREAM 1

HIGHLY RELIABLE
BIT OF STREAM 2

LESS RELIABLE
BIT OF STREAM 2

AFTER
DEINTERLEAVED

Y1

Y2

# FIG.13

STREAM 1

STREAM 2

INPUT BIT SEQUENCE (TRANSMISSION DATA) → TURBO ENCODER (101) → CHANNEL INTERLEAVER (102) → MODULATOR (103) → STREAM MAPPER (104) → IFFT (105A) → TRANSMISSION RF SECTION (106A) → 107A

STREAM MAPPER (104) → IFFT (105B) → TRANSMISSION RF SECTION (106B) → 107B

EP 2 424 143 A1

# FIG.14

EP 2 424 143 A1

# FIG.15

## FIG.16

# FIG.17

# FIG.18

HIGHLY RELIABLE BIT OF STREAM 1

LESS RELIABLE BIT OF STREAM 1

HIGHLY RELIABLE BIT OF STREAM 2

LESS RELIABLE BIT OF STREAM 2

EP 2 424 143 A1

**EP 2 424 143 A1**

<table>
<tr><td colspan="2" style="text-align:center"><b>INTERNATIONAL SEARCH REPORT</b></td><td colspan="2">International application No.<br>PCT/JP2010/001000</td></tr>
</table>

**A. CLASSIFICATION OF SUBJECT MATTER**
*H04J99/00*(2009.01)i, *H03M13/25*(2006.01)i, *H03M13/27*(2006.01)i, *H03M13/29*(2006.01)i, *H04B7/04*(2006.01)i, *H04J11/00*(2006.01)i, *H04L1/00*(2006.01)i

According to International Patent Classification (IPC) or to both national classification and IPC

**B. FIELDS SEARCHED**

Minimum documentation searched (classification system followed by classification symbols)
H04J99/00, H03M13/25, H03M13/27, H03M13/29, H04B7/04, H04J11/00, H04L1/00

Documentation searched other than minimum documentation to the extent that such documents are included in the fields searched
Jitsuyo Shinan Koho          1922–1996     Jitsuyo Shinan Toroku Koho     1996–2010
Kokai Jitsuyo Shinan Koho    1971–2010     Toroku Jitsuyo Shinan Koho     1994–2010

Electronic data base consulted during the international search (name of data base and, where practicable, search terms used)
IEEE Xplore, CiNii

**C. DOCUMENTS CONSIDERED TO BE RELEVANT**

| Category* | Citation of document, with indication, where appropriate, of the relevant passages | Relevant to claim No. |
|---|---|---|
| A | Sukwoo Lee et.al, Bit grouping for IEEE 802.16m CTC, IEEE 802.16m-09/0670, 2009.03.09 | 1-12 |
| A | Xiaofang Wang et.al, New Mapping Schemes for Multi-dimensional Constellation in MIMO-BICM-ID Systems, Communications, 2008. ICC'08. IEEE International Conference on, 2008.05, pp.3599-3603 | 1-12 |
| A | JP 2008-509596 A  (Agency for Science, Technology and Research), 27 March 2008 (27.03.2008), fig. 1, 4 & EP 1774678 A          & WO 2006/014143 A1 & CN 101019340 A | 1-12 |

☒ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>02 April, 2010 (02.04.10) | Date of mailing of the international search report<br>13 April, 2010 (13.04.10) |
|---|---|
| Name and mailing address of the ISA/<br>Japanese Patent Office | Authorized officer |
| Facsimile No. | Telephone No. |

Form PCT/ISA/210 (second sheet) (July 2009)

33

| | INTERNATIONAL SEARCH REPORT | International application No. |
|---|---|---|
| | | PCT/JP2010/001000 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2007-519361 A  (Samsung Electronics Co., Ltd.), 12 July 2007 (12.07.2007), fig. 3 to 9 & US 2005/0160347 A1    & EP 1557966 A2 & WO 2005/069493 A1    & KR 10-2005-0076314 A & CN 1806392 A         & RU 2309538 C | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007519361 T
- JP 2009106566 A